Europäisches Patentamt

European Patent Office

Office européen des brevets

(11) Numéro de publication: **0 093 659**
**A1**

## (12) DEMANDE DE BREVET EUROPEEN

(21) Numéro de dépôt: **83400843.5**

(22) Date de dépôt: **28.04.83**

(51) Int. Cl.³: **H 01 L 23/36**

(30) Priorité: **30.04.82 FR 8207482**

(43) Date de publication de la demande:
**09.11.83 Bulletin 83/45**

(84) Etats contractants désignés:
**DE FR GB IT SE**

(71) Demandeur: **CII HONEYWELL BULL**
**94 Avenue Gambetta**
**F-75990 Paris Cedex 20(FR)**

(72) Inventeur: **Bonnefoy, Jean**
**94 avenue Gambetta**
**F-75020 Paris(FR)**

(74) Mandataire: **Denis, Hervé et al,**
**94, avenue Gambetta**
**F-75020 Paris(FR)**

(54) **Support de dispositifs à circuits intégrés.**

(57) L'invention concerne un support (10) présentant une face (12) qui comporte un réseau métallique d'interconnexion (16) prévu pour recevoir dans au moins une zone (19) une face (23) de surface donnée d'une puce de circuits intégrés (13), et une face (14) prévue pour recevoir un radiateur (15).

Selon l'invention, entre le réseau (16) et la puce (13) est interposé un élément diffuseur (25) bon conducteur thermique, de surface supérieure à celle de la puce (13). L'élément diffuseur (25) peut être une plaque de cuivre fixée au réseau par collage ou une couche de cuivre déposée par sérigraphie.

L'invention s'applique notamment aux machines de traitement de l'information.

FIG. 2

EP 0 093 659 A1

# SUPPORT DE DISPOSITIFS A CIRCUITS INTEGRES

L'invention a pour objet un support de dispositifs à circuits intégrés.

Les dispositifs à circuits intégrés se présentent sous la forme de plaquettes minces (appelées aussi "puces"), dont la grande face avant, dite face active, incorpore les circuits électroniques et présente les bornes d'entrée-sortie sur lesquelles sont généralement fixées des pattes de raccordement (leads). La face arrière ne comporte aucun circuit. Ces deux faces ont une même surface, dont la valeur varie avec le type du dispositif.

Un support de dispositifs à circuits intégrés est formé à partir d'une plaque électriquement isolante, en alumine habituellement, désignée généralement sous le nom de "substrat". La face avant du substrat présente des zones délimitées chacune par des plots destinés à fixer et relier électriquement les pattes ou les bornes d'entrée-sortie d'un dispositif à circuits intégrés. Cette face du substrat comporte aussi un réseau de conducteurs reliant les plots entre eux ainsi qu'à des bornes d'entrée-sortie destinées à la connexion extérieure du support. Ce réseau est formé de plusieurs couches conductrices superposées, espacées par des couches diélectriques.

Un problème important lié aux supports de dispositifs de circuits intégrés réside dans l'évacuation des calories engendrées au niveau des faces actives de ces dispositifs. Etant donné les faibles épaisseurs des plaquettes de silicium constituant les puces, on considère que leurs faces avant et arrière sont pratiquement isothermes. Une solution pour évacuer ces calories consiste à monter sur le support un radiateur en contact thermique avec l'une des faces des dispositifs, de sorte que le support n'a qu'un rôle négligeable pour le refroidissement des dispositifs. L'invention concerne l'autre solution, qui consiste au contraire à donner aux supports un rôle important pour la transmission de la chaleur entre les dispositifs et un dispositif de refroidissement connecté à la face arrière du substrat. Tout dispositif de refroidissement bien connu de la technique peut être utilisé, tel qu'un radiateur à ailettes ou à circulation d'eau par exemple.

Afin de transmettre efficacement les calories produites par les circuits électroniques des dispositifs jusqu'à la face arrière des substrats, les dispositifs ont une de leurs faces formant une plage de contact avec les zones correspondantes de la face avant des substrats. La plage de contact est faite habituellement par une substance de fixation thermocollable, telle qu'une résine époxy. Elles consiste aussi parfois en un soudage par entectique ou en une fusion métal-métal. Dans le cas où les faces actives des dispositifs sont placées en vis-à-vis des zones, la substance de fixation devra être électriquement isolante et bonne conductrice thermique.

Dans les supports, l'expérience montre que la diffusion thermique entre chaque plage de contact et la face arrière du substrat se fait dans un canal sensiblement en forme de tronc de pyramide dont la grande base n'est que légèrement supérieure à la petite base que forme chaque plage de contact. Or, la résistance thermique d'un tel canal étant inversement proportionnelle à la section de celui-ci, ce résultat d'expérience prouve que la résistance thermique est élevée, d'autant plus que le matériau électriquement isolant du substrat et des couches diélectriques du réseau de conducteurs d'interconnexion ne peut avoir qu'un faible coefficient de conductibilité thermique.

Ce problème s'aggrave avec l'emploi actuel de dispositifs à circuits intégrés de haute densité, généralement appelés dispositifs LSI (Large Scale Integration). En effet, la concentration des circuits se traduit par une plus grande dissipation thermique par unité de surface de la face active. Les caractéristiques thermiques du canal d'évacuation de la chaleur étant relativement mauvaises, il est alors très difficile de maintenir la température au niveau de chaque plage à une valeur de seuil souhaitable pour un bon fonctionnement des dispositifs.

L'invention remédie à tous ces inconvénients.

Selon l'invention, un support présentant une face incluant au moins une zone pour recevoir une face de surface donnée d'un dispositif à circuits intégrés est caractérisé en ce que la zone comporte un élément diffuseur bon conducteur thermique, parallèle à ladite face du support et de surface supérieure à ladite surface donnée.

En d'autres termes, l'invention consiste à étendre la section du canal de diffusion de la chaleur à travers le support grâce à un élément diffuseur placé au niveau de chaque zone.

Les caractéristiques et avantages de l'invention ressortiront de la description qui suit, faite en référence aux dessins annexés.

Dans les dessins :

- la figure 1 est une vue fragmentaire de dessus d'un exemple de réalisation d'un support de dispositifs à circuits intégrés conforme à l'invention ;

- la figure 2 est une vue en coupe suivant la ligne II-II de la figure 1 ;

- la figure 3 est un graphe illustrant les avantages du support réprésenté sur les figures 1 et 2 par rapport à un support similaire de la technique antérieure ; et

- la figure 4 est un autre graphe illustrant les avantages d'une variante de support de dispositifs à circuits intégrés conforme à l'invention par rapport au support tel que représenté sur les figures 1 et 2.

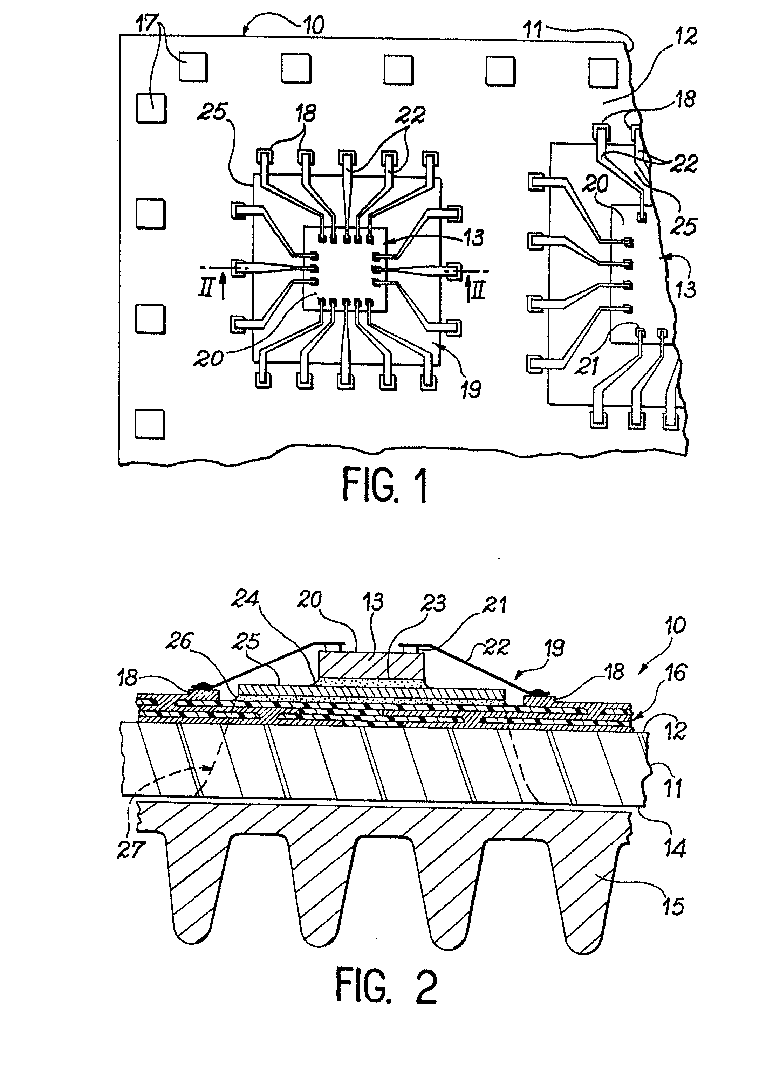

En référence aux figures 1 et 2, un support (10) conforme à l'invention est donné à titre d'exemple. Le support (10) est constitué essentiellement d'un substrat (11) formé par une plaque électriquement isolante, dont la face avant (12) est prévue pour recevoir au moins un dispositif à circuits intégrés (13) et dont la face arrière (14) est destinée à coopérer avec un dispositif de refroidissement (15), un radiateur dans l'exemple illustré. La face avant (12) du substrat (11) supporte un réseau (16) de conducteurs disposés entre des bornes d'entrée-sortie (17) du support (10) et des plots (18) disposés à la périphérie de chaque zone (19) prévue pour recevoir un dispositif à circuits intégrés (13). Selon l'exemple illustré, chaque dispositif (13) présente une face avant ou face active (20) incorporant les éléments des circuits électriques du dispositif (13) et comportant des bornes d'entrée-sortie (21) portant respectivement des pattes de liaison (22), et une face arrière (23). Le montage de chaque dispositif (13) utilise un procédé classique consistant à disposer la face arrière (23) du dispositif (13) sur une couche de fixation (24) disposée au centre de la zone (19) et à souder les extrémités respectives des pattes (22) aux plots (18) entourant la zone (19). La couche de fixation (24) a avantageusement une bonne conductibilité thermique et peut être formée par une couche époxy. La plage de contact du dispositif (13) avec le support (10) a donc, dans cet exemple de fixation de la technique antérieure, la surface de la face arrière (23) du dispositif (13).

Conformément à l'invention, le suppport (10) comporte au niveau de chaque zone (19) un élément diffuseur (25) en matériau bon conducteur thermique, disposé sensiblement parallèlement à la face avant (12) du substrat (11) et ayant une plus grande surface que l'une des faces (20, 23) de chaque dispositif (13). Dans l'exemple illustré, l'élément diffuseur est une feuille de cuivre, qui est fixée sur le réseau (16) dans la zone (19) par une couche (26) et qui supporte la couche de fixation (24) prévue pour recevoir un dispositif (13). La couche de fixation (26) est aussi avantageusement bonne conductrice thermique, formée par exemple par une graisse de silicone.

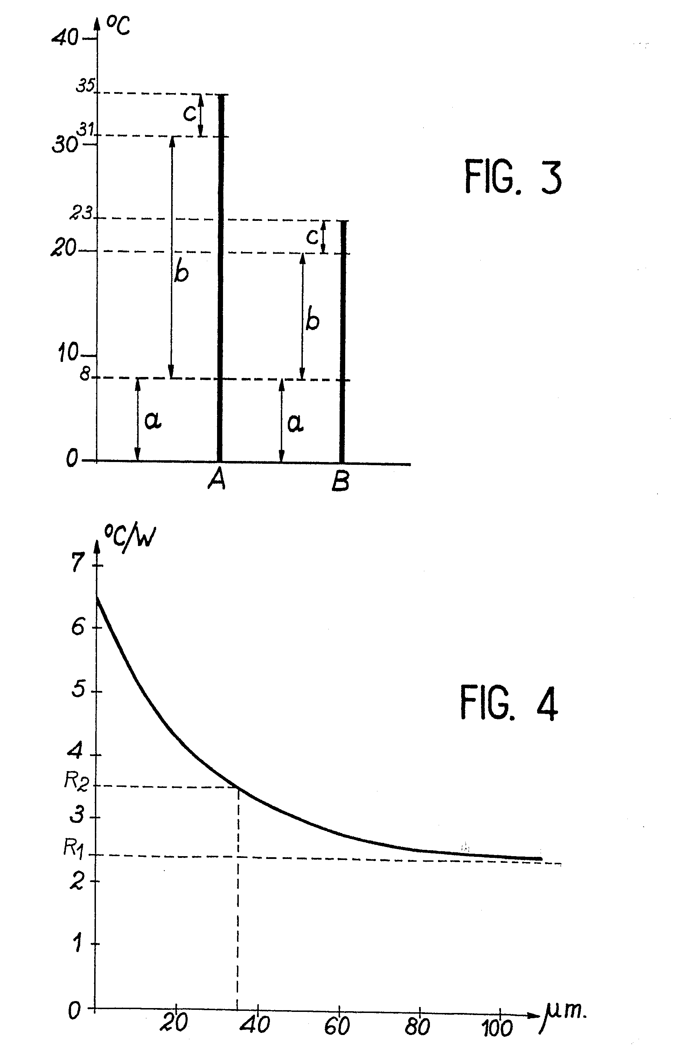

Avec l'élément diffuseur (25), la chaleur dissipée dans la face (20) de chaque dispositif (13) s'écoule de façon pratiquement isotherme jusqu'à la face arrière (23) du dispositif (13), traverse la couche de fixation (24), se répand dans l'élément diffuseur (25) et traverse ensuite le réseau (16) et le substrat (11), suivant un canal (27) sensiblement pyramidal, dont la petite base est alors constituée par la surface de l'élément (25) et la grande base par une partie de la face arrière (14) du substrat (11). La surface de l'élément diffuseur (25) étant notablement plus élevée que celle des faces (20, 23) du dispositif (13), le canal d'évacuation de chaleur (27) a donc dans un support (10) conforme à l'invention une section nettement plus élevée que celle du canal existant dans le support antérieur. Le large canal (27) offre donc une résistance thermique très diminuée à l'écoulement de la chaleur ainsi qu'une plus grand capacité à évacuer de fortes énergies calorifiques. En d'autres termes, il existera par rapport à la technique antérieure une différence de température moins importante entre un dispositif (13) et le dispositif de refroidissement (15), comme cela apparaît à la figure 3.

Les avantages de l'invention ressortent clairement du graphe de la figure 3 exposant des résultats d'expériences avec et sans l'utilisation d'un élément diffuseur (25), toutes choses étant égales par ailleurs. L'axe des ordonnées du graphe est représentatif de différences de températures mesurées en °C, tandis que l'axe des abscisses se rapporte à la température au niveau de la face (20) du dispositif (13) et supporte deux segments (A, B) exposant les résultats de deux expériences faites avec un dispositif (13) de 2,7mm x 2,7mm de côté, dissipant 1,3 Watt. Le segment (A) correspond à un support de la technique antérieure selon laquelle le dispositif (13) est collé directement sur le réseau (16) dans la zone (19), sans l'intermédiaire d'un élément diffuseur (25) conforme à l'invention ; le segment (B) correspond au montage de ce dispositif par l'intermédiaire d'un élément diffuseur (25) formé par une feuille carrée en cuivre de 4,5mm de côté et de 0,1mm d'épaisseur.

Les segments (A) et (B) se composent de trois sous-segments (a, b, c) qui représentent chacun une différence de températures prélevées respectivement : pour le sous-segment (a) entre la face active (20) du dispositif (13) et la face supérieure du réseau (16) dans la zone (19), pour le sous-segment (b) entre la face supérieure du réseau (16) dans la zone (19) et la face avant (12) du substrat (11), et pour le sous-segment (c) entre la face avant (12) et la face arrière (14) du substrat (11). Comme cela ressort de la figure 3, les sous-segments (a) des segments (A) et (B) sont égaux et correspondent à 8°C, tandis que le sous-segment (b) correspond à 23°C pour le segment (A) et à 12°C seulement pour le segment (B), si bien que l'élément diffuseur (25) fait gagner dans ce cas 11°C pour l'évacuation de la chaleur seulement à travers le réseau (16). Enfin, le sous-segment (c) correspond à 4°C pour le segment (A) et à 3°C pour le segment (B) entre les faces (12) et (14) du substrat (11). Le fait que le sous-segment (b) soit prédominant est dû à la forte résistance thermique de la matière électriquement isolante qui englobe le réseau métallique d'interconnexion (16). En gagnant encore 1°C à travers le substrat, le gain total est donc de 12°C sur 27°C (sous-segments b+c du segment A) entre la base de la couche de fixation (24) du dispositif (13) et la face arrière (14) du substrat (11).

L'élément diffuseur (25) pourrait être formé d'une tout autre manière, par exemple par sérigraphie en même temps que la formation du réseau (16) porté par la face (12a) du substrat (11). Dans ce cas, il pourrait être constitué par l'une quelconque des couches nécessaires pour la formation du réseau (16), ou par une couche supplémentaire placée sur le réseau (16) dans une zone (29). L'avantage à disposer l'élément diffuseur dans le réseau (16) résiderait essentiellement dans la disposition compacte des plots (18), qui pourraient être ainsi disposés immédiatement aux côtés de chaque dispositif (13). Cette disposition permettrait aussi la fixation de dispositifs (13) sans pattes (22) par connexion directe des bornes (21) aux plots (18). Dans ce cas, la couche (24) serait en contact avec la face active (20) des dispositifs (13).

La figure 4 est un graphe illustrant un résultat d'expériences conduites pour mesurer l'efficacité d'un élément diffuseur (25) formé par une couche de cuivre déposée par sérigraphie sur le réseau (16) dans une zone (29) en fonction de l'épaisseur donnée à cette couche de cuivre. Les expériences ont été faites avec un dispositif (13) de 6mm x 5mm fixé par une couche (24) à une couche de cuivre (25) de 12mm x 12mm déposée sur un réseau (16) de 245 micromètres. Les ordonnées du graphe de la figure 4 représentent la résistance thermique en °C/Watt entre l'élément diffuseur (25) et la face avant (12) du substrat

0093659

- 8 -

(11), tandis que les abscisses représentent l'épaisseur en micromètres de l'élément diffuseur (25). On voit que l'efficacité varie beaucoup pour de faibles épaisseurs de la couche de diffusion (25), et qu'elle tend ensuite vers une valeur asymptotique $R_1$ de 2,4°C/Watt au-delà de 75 micromètres dans l'exemple illustré. A titre indicatif, on a mesuré dans les mêmes conditions la résistance $R_2$ = 3,5°C/watt avec un élément diffuseur (25) de même surface, formé par une feuille de cuivre de 200 micromètres d'épaisseur et collé sur le réseau comme aux figures 1 et 2, alors que la même résistance $R_2$ est obtenue avec une épaisseur de couche déposée par sérigraphie d'environ 35 micromètres. Une telle différence s'expliquerait d'après les sous-segments (a) de la figure 3, où on voit qu'une couche de fixation telle que (24) ou (26) apporte une résistance thermique notable dans le chemin d'évacuation de la chaleur.

## REVENDICATIONS

1. Support (10) présentant une face (12) comportant au moins une zone (19) pour recevoir une face (23) de surface donnée d'un dispositif à circuits intégrés (13), caractérisé en ce que la zone comporte un élément diffuseur (25) bon conducteur thermique, parallèle à ladite face du support et de surface supérieure à ladite surface donnée.

2. Support selon la revendication 1, caractérisé en ce que l'élément diffuseur (25) est une feuille fixée sur le support.

3. Support selon la revendication 1, caractérisé en ce que l'élément diffuseur (25) est déposé sur ladite face (12) du support, par sérigraphie par exemple.

4. Support selon la revendication 3, caractérisé en ce que l'élément diffuseur (25) est une couche d'un réseau de conducteurs (16) formé sur la face (12).

1/2

0093659

FIG. 1

FIG. 2

FIG. 3

FIG. 4

0093659 A348

Numéro de la demande

Office européen
des brevets

**RAPPORT DE RECHERCHE EUROPEENNE**

EP  83 40 0843

| | **DOCUMENTS CONSIDERES COMME PERTINENTS** | | |
|---|---|---|---|
| Catégorie | Citation du document avec indication, en cas de besoin, des parties pertinentes | Revendication concernée | CLASSEMENT DE LA DEMANDE (Int. Cl. ³) |
| X | FR-A-2 306 530  (I.B.M.)<br>* Figure 3; revendications 1,7;<br>page 3, lignes 15-22 * | 1,4 | H 01 L  23/36 |
| X | IBM TECHNICAL DISCLOSURE<br>BULLETIN, vol. 19, no. 9,<br>février 1977, pages 3321-3322,<br>New York, USA<br>N.C. ARVANITAKIS: "Modular organ-<br>ic carrier" * Page 3321, alinéa 2<br>* | 1,4 | |
| A | IBM TECHNICAL DISCLOSURE<br>BULLETIN, vol. 21, no. 4,<br>septembre 1978, pages 1473-1474,<br>New York, USA<br>A.J.  ARNOLD et al.: "Module with<br>internal  elements  for  reducing<br>thermal resistance" | 2 | DOMAINES TECHNIQUES RECHERCHES (Int. Cl. ³) |
| A | IBM TECHNICAL DISCLOSURE<br>BULLETIN, vol. 21, no. 7,<br>décembre 1978, page 2709, New<br>York, USA<br>P.  BAKOS et al.: "Thermal grease<br>in  integrated circuit modules" *<br>Alinéa 4 * | 3 | H 01 L |

Le présent rapport de recherche a été établi pour toutes les revendications

| Lieu de la recherche<br>LA HAYE | Date d'achèvement de la recherche<br>08-08-1983 | Examinateur<br>DE RAEVE R.A.L. |
|---|---|---|

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

OEB Form 1503. 03.82